# EUROPEAN PATENT APPLICATION

(11) **EP 1 109 217 A1**
(43) Date of publication of application: **20.06.2001**
(21) Application number: 99830770.6
(22) Date of filing: 13.12.1999
(51) Int. Cl.: H01L 21/8239, H01L 21/8247

(54) **Method of manufacturing low and high voltage CMOS transistors with EPROM cells**

(71) Applicant: STMicroelectronics S.r.l., 20041 Agrate Brianza (Milano) (IT)
(72) Inventor: Palumbo, Elisabetta, 20155 Milano (IT); Peschiaroli, Daniela, 20131 Milano (IT); Zatelli, Nicola, 24100 Bergamo (IT)
(74) Representative: Maggioni, Claudio

(57) **Abstract**

The body regions for the n-channel and p-channel LV transistors, for the n-channel HV transistors, and for the EPROM cells are formed on a silicon substrate; a thermal oxide layer (12) is formed and a layer of polycrystalline silicon (13) is formed thereon; the latter layer is selectively removed to form the floating gate electrodes (13a) of the cells and the gate electrodes (13b) of the HV transistors; the source and drain regions (14) of the cells, the source and drain regions (22) of the n-channel HV transistors, the body regions (24) and the source and drain regions of the p-channel HV transistors are formed; an ONO composite layer (15) is formed; the silicon of the areas of the LV transistors is exposed; a thermal oxide layer (16) is formed on the exposed areas; a second polycrystalline silicon layer (17) is deposited and is then removed selectively to form the gate electrodes of the LV transistors (17c) and the control gate electrodes (17a) of the cells, and the source and drain regions of the LV transistors are formed.

By virtue of the use of a material (ONO) which is impermeable to the oxygen atoms of the subsequent thermal oxidation and because the body regions (24) of the p-channel HV transistors and the source and drain regions of all of the HV transistors are produced by separate implantations, components of very good quality are produced with few more masks than a conventional LV method.

## Description

The present invention relates to the manufacture of integrated circuits and, more particularly, to a method of forming, on a silicon substrate, an integrated circuit comprising low-voltage complementary MOS transistors with respective gate electrodes separated from the substrate by a portion of a first layer of dielectric material, high-voltage complementary MOS transistors with respective gate electrodes separated from the substrate by a portion of a second dielectric material, and EPROM cells with respective floating gate electrodes separated from the substrate by a portion of the second layer of dielectric material and with respective control electrodes separated from the respective floating gate electrodes by a portion of a third layer of dielectric material.

In the design of integrated-circuit devices for logic processing of digital signals, for example, microprocessors, there is sometimes a need to incorporate, in the same integrated circuit, electrically programmable, non-volatile memory cells known as EPROM (electrically-programmable, read-only memory) cells of the type which can be programmed only once, that is, of the OTP (one-time programmable) type, and the respective decoding circuits. This requirement poses considerable construction problems, for the following reason. Logic processing circuits, or briefly, logic circuits, are advantageously produced by low-voltage technologies, that is, by processes for forming devices, particularly MOS transistors, which can withstand relatively low voltages (1-3V) (indicated below by the initials LV - low voltage). However, the memory decoding circuits require devices, basically MOS transistors, which can operate at relatively high voltages (7-10V) (indicated below by the initials HV - high voltage). This means that the gate dielectrics of the HV devices have to have different physical characteristics and/or thicknesses from those used in the LV devices, so that specific operations are required to form and define them.

A method according to the prior art for forming devices of different types in the same integrated circuit is constituted by the combination of the three specific methods for the formation of devices of the three types, that is, by a method which provides for a number of masking steps approaching the sum of the masking steps of the three specific methods. However, a method of this type involves high costs, not only because of the time required for the large number of necessary steps, but also because of the resulting low output. In fact, as is known, production output decreases as the number of steps of the method increases.

In order to produce HV circuits together with LV circuits without the use of specific methods for HV devices, a circuit arrangement is known which provides for the use of two or more LV devices connected in a cascode configuration. However, this solution can be implemented advantageously only when there are few HV devices; otherwise, in view of the fact that each HV device is formed by at least two LV devices, the additional area required becomes unacceptable. Moreover, this solution is of no assistance in the formation of the memory cells so that it is in any case necessary to add to the method all of the steps specific to the production of memory cells.

The main object of the present invention is to propose a method which enables LV circuits, HV circuits and OTP EPROM memory cells to be formed in the same circuit with the use of few steps in addition to the conventional steps for the formation of LV circuits, in order thus to achieve a production output very close to that which can be achieved by a method for forming logic circuits with LV transistors alone.

This object is achieved by the implementation of the method defined in general in the first claim.

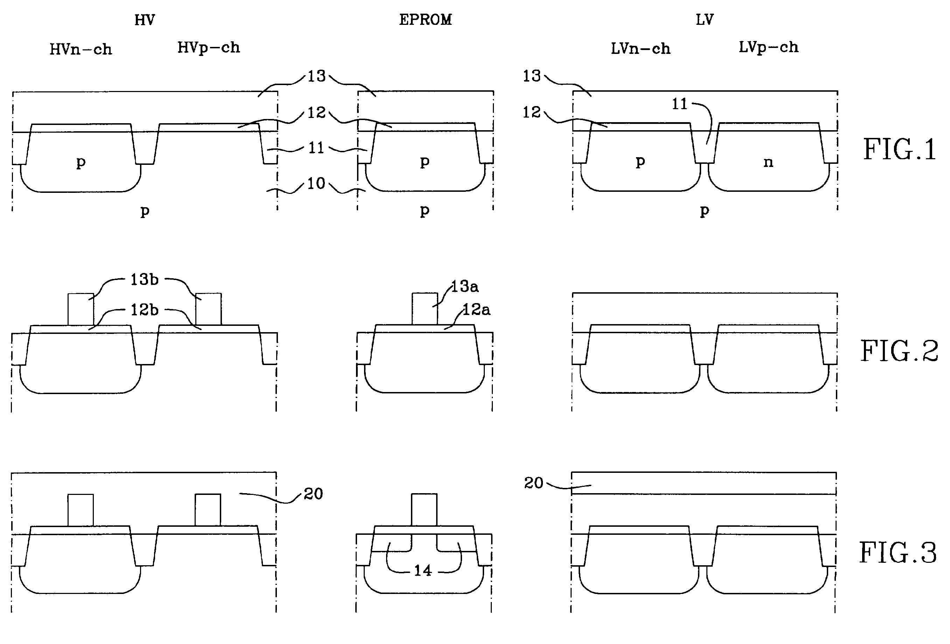

The invention will be understood better from the following detailed description of a non-limiting example, given with reference to the appended drawings, in which Figures 1 to 10 show, in section, schematically and not to scale, three portions of an integrated circuit formed on a monocrystalline silicon wafer, at successive stages of the method according to the invention.

The three portions shown relate to a pair of complementary low-voltage MOS transistors, indicated LV, that is, an n-channel transistor and a p-channel transistor, indicated LVn-ch and LVp-ch, respectively, and to a pair of complementary high-voltage transistors, indicated HV, that is, an n-channel transistor and a p-channel transistor, indicated HVn-ch and HVp-ch, respectively, and to a cell, indicated EPROM, of a matrix of EPROM cells.

Figure 1 shows the structures of the three portions after a series of steps of the method according to the invention for the manufacture of an integrated circuit. These steps comprise, first of all, the definition, on a monocrystalline silicon substrate 10, of so-called active p-type areas isolated from one another by silicon dioxide inserts 11, that is, the so-called field oxide, and the subsequent doping of the active areas, with the exclusion of those intended for the p-channel HV MOS transistors. The p-type and n-type regions which are to constitute the body regions of the n-channel and p-channel LV MOS transistors, the body regions of the n-channel HV MOS transistors and the body regions of the EPROM cells are thus formed.

A relatively thin layer 12 (5-lOnm) of silicon dioxide is then formed by thermal oxidation of the silicon of the substrate and, finally, a layer 13 of polycrystalline silicon doped with n-type impurities is formed on the oxide layer 12.

The polycrystalline silicon is removed selectively from the areas intended for the EPROM cells and from those intended for the HV MOS transistors with the use of known photolithography techniques to form the floating gate electrodes of the EPROM cells and the gate electrodes of the HV MOS transistors. Figure 2 shows a single floating gate electrode, indicated 13a, and the gate electrodes, indicated 13b, of the HV MOS transistors. The portion, indicated 12a, of the thin oxide layer 12 which is disposed beneath the gate electrode 13a constitutes the gate dielectric of the EPROM cell and the portions, indicated 12b, which are disposed beneath the gate electrodes 13b constitute the gate dielectric of the HV MOS transistors.

The areas intended for the HV and LV MOS transistors are covered with a photoresist mask 20 in order for the p-type body region of the cells to be subjected to implantation with doping impurities such as to form n-type source and drain regions indicated 14 in Figure 3.

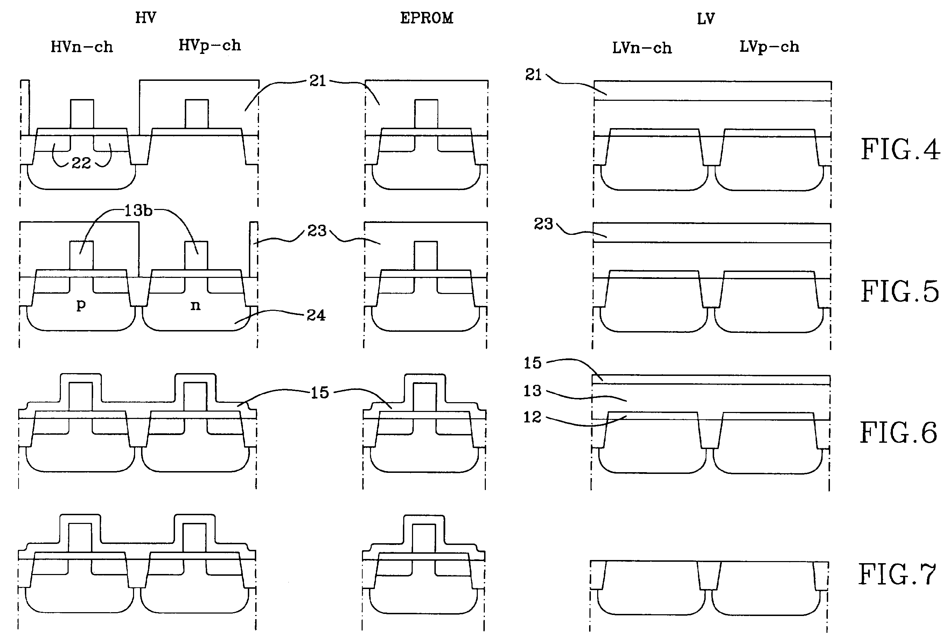

All of the areas except for those intended for the n-channel HV transistors are masked by a second photoresist mask 21 in order for doping impurities to be implanted in the body region of the n-channel HV transistors so as to form n-type source and drain regions, indicated 22 in Figure 4.

All of the areas except those intended for the p-channel HV MOS transistors are masked with a third photoresist mask 23 in order for doping impurities, for example, arsenic ions, to be implanted to form n-type body regions of the p-channel HV transistors. The implantation is performed with relatively high dose and energy so that, in spite of the masking effect of the gate electrodes, relatively uniform n-type regions 24 are formed upon completion of the high-temperature operations to which the wafer is subjected after implantation. It will be noted that this implantation does not appreciably alter the gate electrodes of the p-channel HV transistors because it uses doping impurities of the same type (n) as those of the polycrystalline silicon of the layer 13.

P-type doping impurities are then implanted in the body regions 24 to form source and drain regions, with the use of the same mask 23. The implantation energy in this case is relatively low so that the gate electrodes 13b of the p-channel HV transistors effectively mask the underlying silicon regions and thus constitute part of the implantation mask.

After the removal of the third photoresist mask 23, a layer 15 of composite dielectric material of the type known to experts in the art by the initials ONO (oxidenitride-oxide) is thus formed on the entire wafer (Figure 6). This layer is produced by the deposition, in succession, of a first silicon dioxide layer (for example, with a thickness of between 30 and 80 nm), of a silicon nitride layer (for example, with a thickness of between 30 and 80 nm), and of a second silicon dioxide layer (for example, with a thickness of between 30 and 80 nm).

The composite layer 15 is intended to constitute the intermediate dielectric of the EPROM cells.

By virtue of the presence of silicon nitride in the composite layer 15, according to the invention, a subsequent thermal oxidation step on other areas of the substrate is possible. The nitride layer in fact prevents oxygen atoms from reaching the surface of the substrate in order to combine with the silicon and form an oxide layer which would undesirably increase the thickness of the dielectric of the HV transistors.

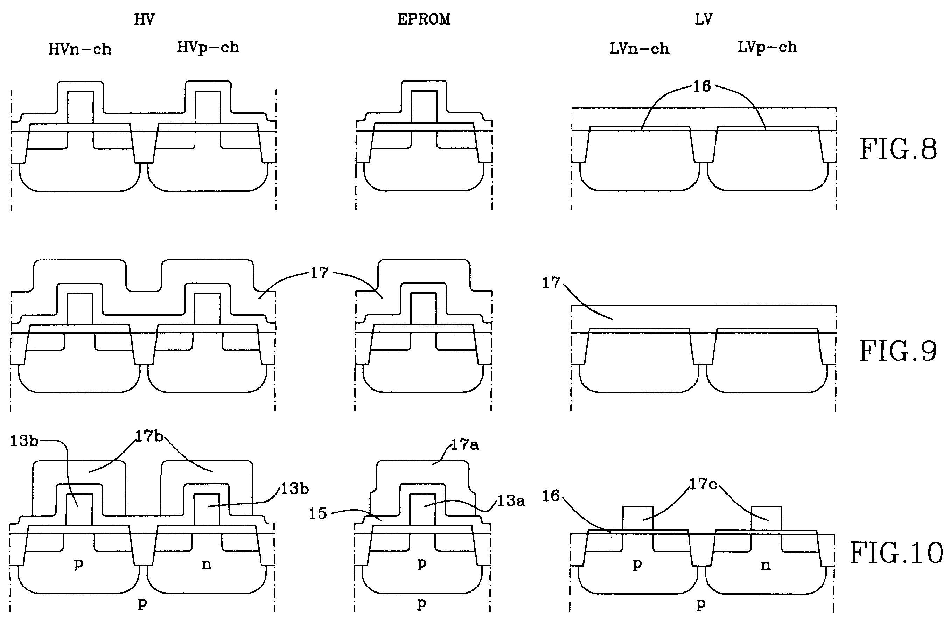

The areas of the substrate involved in this thermal oxidation step are those which are intended for the LV transistors. In order to be subjected to thermal oxidation, these are first of all cleared of all of the layers formed on them by the previous steps, by suitable etching (Figure 7). The parameters for this processing step are selected in a manner such as to form a layer 16 of silicon dioxide of the thickness required for the gate dielectric of the LV transistors (for example, 5 nm) (Figure 8).

A second layer of non-doped polycrystalline silicon, indicated 17, (Figure 9) is then deposited on the entire wafer. The polycrystalline silicon of this layer is removed selectively by known photolithography techniques to form the control gate electrodes 17a (Figure 10) of the EPROM cells, the gate electrodes 17c of the LV transistors, and isolated electrically-conductive portions 17b disposed above the gate electrodes 13b of the p-channel HV transistors. In the preferred embodiment of the invention, the electrically-conductive portions 17b are electrically connected to the respective gate electrodes 13b by means of suitable conductive vias which extend through the composite dielectric layer 15. This prevents undesired capacitive effects which could prejudice the correct operation of the HV transistors. Alternatively, the conductive portions 17b may be completely removed by suitable etching operations, after masking of the gate electrodes 17a and 17c.

Finally, the source and drain regions of the transistors are formed (Figure 10) in the body regions of the LV transistors, in conventional manner, by suitable masking and implantation of n-type doping impurities for the n-channel transistors and p-type doping impurities for the p-channel transistors.

The method continues with the conventional steps for the formation of metal connections between the components of the integrated circuit, coating with a protective dielectric layer, formation of contact terminal electrodes of the integrated circuit, cutting of the wafer into chips and mounting of the individual chips in suitable housing and interconnection structures for connection to an external circuit.

The method according to the invention produces EPROM memory cells which can safely be programmed, with a very good guarantee of stability, more than one single time, by virtue of the good characteristics of the composite material (ONO) used for the intermediate dielectric and, at the same time, produces HV transistors of very good quality by virtue of the fact that the body regions of the p-channel HV transistors and the source and drain regions of all of the HV transistors are produced by implantation steps which are intended for their formation alone and which are thus optimized with regard to dose and energy. Moreover, these results are achieved with the use of few masks in addition to those which are necessary for a conventional method for the manufacture of integrated logic circuits containing only LV transistors. The total number of masks is therefore much smaller than that of a method constituted by a combination of the known specific methods for the formation of LV transistors, EPROM cells and HV transistors. The method according to the invention is consequently very advantageous in terms of production costs, both because the total processing time is reduced and because production output is relatively high. Moreover, it should be noted that the additional operations do not interfere with the conventional steps for the formation of the constituent elements characteristic of LV transistors (thermal oxide for the gate dielectric, body, source and drain implantions) so that the logic circuits which can be produced by the method according to the invention are no different from those which can be produced by a conventional method intended purely for circuits of this type.

## Claims

1. A method of forming, on a silicon substrate, an integrated circuit comprising n-channel and p-channel LV MOS transistors with respective gate electrodes separated from the substrate by a portion of a first layer of dielectric material (16), n-channel and p-channel HV MOS transistors with respective gate electrodes separated from the substrate by a portion (12b) of a second layer of dielectric material (12), and EPROM cells with respective floating gate electrodes (13a) separated from the substrate by a portion (12a) of the second layer of dielectric material (12) and with respective control electrodes (17a) separated from the respective floating gate electrodes (13a) by a portion of a third layer of dielectric material (15), the method comprising the following steps:
a. defining, on the substrate, areas intended for the LV MOS transistors, for the HV MOS transistors, and for the EPROM cells,
b. forming p-type and n-type body regions for the n-channel and p-channel LV MOS transistors, respectively, and p-type body regions for the n-channel HV MOS transistors and for the EPROM cells, in the respective areas,
c. forming the second layer of dielectric material (12) on all of the exposed areas of the substrate,
d. forming a first layer of polycrystalline silicon (13) with n-type conductivity on the second layer of dielectric material (12),
e. selectively removing the polycrystalline silicon from the areas intended for the EPROM cells to form the floating gate electrodes (13a) of the cells, and from the areas intended for the HV MOS transistors to form the gate electrodes (13b) of the HV transistors,
f. implanting n-type impurities in the body regions of the EPROM cells to form source and drain regions (14) of the cells,
g. implanting n-type impurities in the body regions of the n-channel HV transistors to form source and drain regions (22),
h. implanting n-type impurities in the areas intended for the p-channel HV transistors to form body regions (24) of the p-channel HV transistors and implanting p-type impurities in the body regions (24) of the p-channel HV transistors to form source and drain regions in these body regions with the use of the gate electrodes of the p-channel HV MOS transistors as masks,
i. forming the third layer of dielectric material (15) on all of the areas,
j. removing the dielectric material of the third layer (15), the polycrystalline silicon (13), and the dielectric material of the second layer (12) from the areas intended for the LV MOS transistors until the silicon of the substrate is exposed,
k. forming the first layer of dielectric material (16) on the silicon exposed by the previous step,
l. forming a second layer of polycrystalline silicon (17) on all of the areas, m. selectively removing the polycrystalline silicon of the second polycrystalline silicon layer (17) to form the gate electrodes (17c) of the LV MOS transistors and the control gate electrodes (17a) of the EPROM cells, and n. forming source and drain regions in the body regions of the LV MOS transistors.

2. A method according to Claim 1, in which step m) comprises the complete removal of the polycrystalline silicon of the second polycrystalline silicon layer (17) from the areas intended for the HV MOS transistors.

3. A method according to Claim 1, in which step m. comprises the selective removal of the polycrystalline silicon of the second polycrystalline silicon layer (17) from the areas intended for the HV MOS transistors to form portions of polycrystalline silicon which are separate from one another and each of which is superimposed on the gate electrode of an HV MOS transistor.

4. A method according to Claim 3, comprising a step for connecting the separate portions of polycrystalline silicon to the gate electrodes of the respective HV MOS transistors.

5. A method according to any one of the preceding claims, in which step i. comprises the deposition, in succession, of a first silicon dioxide layer, a silicon nitride layer and a second silicon dioxide layer.

6. A method according to any one of the preceding claims, in which step c. comprises oxidation treatment of the silicon.

7. A method according to any one of the preceding claims, in which step h. comprises oxidation treatment of the silicon.
